# EUROPEAN PATENT APPLICATION

(11) **EP 4 404 268 A1**
(43) Date of publication of application: **24.07.2024**
(21) Application number: 23152584.1
(22) Date of filing: 20.01.2023
(51) Int. Cl.: H01L 29/06, H01L 29/872, H01L 23/31, H01L 29/16, H01L 29/20

(54) **SEMICONDUCTOR DEVICE WITH IMPROVED CONTROL OF SURFACE CHARGES IN TERMINATION**

(71) Applicant: Nexperia B.V., 6534 AB Nijmegen (NL)
(72) Inventor: El-Zammar, Georgio, Hamburg (DE); Mazzillo, Massimo Cataldo, Hamburg (DE); Habenicht, Sönke, 22529 Hamburg (DE)
(74) Representative: Pjanovic, Ilija

(57) **Abstract**

The present disclosure relates to a semiconductor device that comprises a semiconductor body including a semiconductor substrate and an epitaxial layer formed on the semiconductor substrate. An active area and a termination area adjacent the active area are arranged in the epitaxial layer. The termination area comprises a junction termination extension, JTE, border of a first conductivity type. The JTE border comprises a first layer of the first conductivity type, and a second layer of a second conductivity type different from the first conductivity type. The second layer is located on top of the first layer. The semiconductor substrate and the epitaxial layer have the second conductivity type.

## Description

### TECHNICAL FIELD

The present disclosure generally relates to a semiconductor device, in particular to a Silicon Carbide (SiC), Merged P-I-N Schottky (MPS) diode.

### BACKGROUND

High voltage semiconductor devices in general and Silicon Carbide (SiC) products in particular use many structures surrounding the active area. Jointly, these structures are referred to as termination area. It is of utmost importance for these devices to design a robust termination area able to withstand high voltages in the kV range. The main role of the termination area is to spread the potential lines in a manner to avoid crowding at particular regions of the termination area. Consequently, the termination area helps reducing the electric field at the edge of the active area, and when well designed, the termination area spreads equally the field across all the elements of the termination area avoiding any extreme field crowding at weak spots.

Weak spots or areas can be caused by design issues, e.g. unoptimized dimensions, process variation, e.g. lithography misalignment, ion implantation and diffusion, e.g. dose, energy and activation temperature, as well as interface charges caused by the presence of a passivation in the termination area. When using a nitride-based passivation, these charges are "positive", meaning ionized acceptors will accumulate in the semiconductor body at the termination area in order to compensate the holes trapped at the interface. In addition, these charges can be mobile or change polarity during reliability. The impact of these passivation charges can be crucial. It results in an undesired depletion region at 0V that reduces the effectivity of the termination area, causing low or unstable reverse blocking capability, poor unclamped inductive switching ruggedness, high temperature and high-voltage reliability failures, and limits fields of application for such a product.

In known termination areas the impact of passivation charges is always visible. An example of a termination area uses the concept of a large, lowly doped p-type area called junction termination extension (JTE) border. JTE allows to spread the equipotential lines coming from under the junction edge toward the surface. This JTE border can be coupled with floating guard rings, also known as Kao rings. These floating guard rings consist of multiple areas of low P-type doping, generally the same level of doping as the JTE border, with fixed width and spacing.

### SUMMARY

It is an object of the present disclosure to provide a semiconductor device with an improved product performance.

It is a further object of the disclosure to provide a semiconductor device with a reduced impact of passivation charges.

It is a further object of the disclosure to provide a semiconductor device with an improved ruggedness.

The present disclosure relates to a semiconductor device that comprises a semiconductor body including a semiconductor substrate and an epitaxial layer formed on the semiconductor substrate. An active area and a termination area adjacent the active area are arranged in the epitaxial layer. The termination area comprises a junction termination extension, JTE, border of a first conductivity type. The JTE border comprises a first layer of the first conductivity type, and a second layer of a second conductivity type different from the first conductivity type. The second layer is located on top of the first layer. The semiconductor substrate and the epitaxial layer have the second conductivity type.

Without wishing to be bound by theory, the inventors believe that a reduced effect of the abovementioned surface charges on the performance of the semiconductor device is achieved by the JTE border including a first layer of a first conductivity type and, located on top of this layer, a second layer of a second conductivity type. Furthermore, this allows for a controlled depletion region allowing for further process variation (for example in lithography or ion implantation).

A summary of aspects of certain examples disclosed herein is set forth below. It should be understood that these aspects are presented merely to provide the reader with a brief summary of these certain examples and that these aspects are not intended to limit the scope of this disclosure. Indeed, this disclosure may encompass a variety of aspects and/or a combination of aspects that may not be set forth.

The phrase "the second layer is located on top of the first layer" is not meant to mean that the first layer should be covered completely by the second layer, it is merely an indication of respective location. The second layer may fully cover the top of the first layer, but the first layer may also extend further in a lateral direction. And vice versa, the second layer may also extend beyond the first layer in the lateral direction. It is also possible that the first layers extend beyond the second layer on one side (e.g. towards the active area), while the second layer extends beyond the first layer on the other side - or vice versa.

In an example of the semiconductor device according to the present disclosure, a dopant concentration in the epitaxial layer associated with the second conductivity type is smaller than a dopant concentration in the second layer associated with the second conductivity type. In a specific example of this, the dopant concentration of the JTE border associated with the first conductivity type is at least 20 times smaller than the dopant concentration of the first layer associated with the first conductivity type. The dopant concentration of the JTE border associated with the first conductivity type may be at least 50 times smaller, such as at least 100 times smaller. For example, the dopant concentration of the first layer associated with the first conductivity type may lie in a range between 1E19 and 5E20 #/cm3, and the dopant concentration of the JTE border associated with the first conductivity type may lie in a range between 1E17 and 1E18 #/cm3.

In a further example, a dopant concentration in the second layer associated with the second conductivity type is at least 100 times larger than the dopant concentration in the epitaxial layer associated with the second conductivity type. In a specific example, this dopant concentration is at least 1000 times larger, such as at least 10000 times larger. As an example, the dopant concentration in the second layer associated with the second conductivity type may lie in range between 1E19 and 5E20 #/cm3.

In an example, the epitaxial layer doping may lay in the range of 1 E15 and 5E16 #/cm3.

In a further example, the first and second layers are configured to be electrically floating during operation.

In a further example, the device further comprises a floating bias metal contact connected to the second layer for providing a bias voltage to said second layer. The metal contact serves to provide a reference bias to the second layer while the first layer underneath is contacted through the JTE connected in turn to the active area. Fixing a bias for the region of the second conductivity type, provides more stable working conditions for the junction between the first and second conductivity type in the JTE (even less influenced by surface charging in the passivation). The second layer may be floating or grounded at zero bias (as the substrate), supposing the external bias (different from zero) is applied only to the doped part of the first conductivity type of the junction (i.e. to the anode).

In a further example, the termination area further comprises a plurality of floating JTE rings of the first conductivity type arranged spaced apart from the JTE border. In a specific example of this, each of the plurality of floating JTE rings comprises a first layer of the first conductivity type, and a second layer of a second conductivity type different from the first conductivity type. The second layer is located on top of the first layer. A dopant concentration of the floating JTE rings associated with the first polarity may lie in a range between 1E17 and 1E18 #/cm3.

In a further example, the device further comprises a passivation layer. In this example, the termination area is at least partially covered by the passivation layer. The passivation layer may comprise Silicon Nitride, Silicon Oxynitride, Silicon Oxide or a Metallic Oxide. Additionally or alternatively, the passivation layer may comprise a field oxide for example made of Silicon Oxide. When the passivation layer comprises a field oxide, the field oxide may cover the termination area substantially in its entirety and optionally also part of the active area. This field oxide may be covered by other passivation layers, such as one or more of the layers mentioned above. When the passivation layer does not comprise the field oxide, the passivation layer may cover the termination area only partially.

In a further example, the device further comprises a channel stopper arranged at or near an edge of the semiconductor device. In this example, the termination area is arranged in between the channel stopper and the active area, and the channel stopper is of the second conductivity type. A dopant concentration of the channel stopper associated with the second polarity may lie in a range between 1E18 and 1E20 #/cm3.

In a further example, the layer of the second conductivity type is under the passivation layer, when the passivation layer is in direct contact with the semiconductor. The layer of the second conductivity type in the termination can preferably not be contacted by the same metal layer used to contact the doped part of the first conductivity type of the termination. The layer of the second conductivity type can be floating or contacted by another metal layer. In a more specific example, the lateral distance between the passivation layer and the active area is larger than the lateral distance between the second layer and the active area. In other words, the passivation layer is covered, at a bottom side, by the second layer at least on the side of the active area.

The abovementioned passivation layer may extend over the termination area from a region directly above the channel stopper towards the active area thereby covering at least part of the second layer. For example, at least 90 percent of the second layer may be covered, preferably at least 95 percent, and more preferably at least 98 percent.

The abovementioned field oxide may extend over the termination area from a region directly above the channel stopper towards the active area thereby fully covering the second layer.

In a further example, the semiconductor device comprises a Merged P-I-N Schottky, MPS, diode, a MOSFET, a JFET, a Schottky barrier, or a PN diode.

In a further example, the semiconductor device comprises a MPS diode, and the active area comprises a conductive layer assembly comprising one or more conductive layers, such as a metal layers; and a plurality of mutually separated islands of the first conductivity type arranged in a current distribution layer of the second conductivity type. The conductive layer assembly forms Schottky contacts with the current distribution layer, and the conductive layer assembly forms Ohmic contacts with the plurality of islands of the first conductivity type. In some examples, an Ohmic contact is formed with a different metal or conductive layer than the Schottky contact. The combination of these different metal or conductive layers is referred to as conductive layer assembly. In addition, the conductive layer assembly may comprise relatively thick metal layers for providing low Ohmic resistance, especially when handling high currents. Furthermore, the conductive layer assembly may form a first contact of the MPS diode, and the MPS diode may comprise a second contact arranged on the semiconductor substrate. The current distribution layer can be formed by a well of the second conductivity type formed in the epitaxial layer, wherein a dopant concentration of the current distribution layer associated with the second conductivity type is 2 times larger than a dopant concentration of the epitaxial layer associated with the second conductivity type, preferably 3 times larger, more preferably 5 times larger.

In a further example, the semiconductor substrate comprises a Group II, III, IV, V, or VI element. In a specific example, the substrate is selected from Silicon Carbide, Silicon, Gallium Nitride, and Aluminum Gallium Nitride. More specifically, the substrate may be Silicon Carbide.

In a further example, the first conductivity type corresponds to p-type and the second conductivity type to n-type.

In an example the layers of the first and second conductivity type are implants located below the passivation. These implants are preferably shallow implants. As such, they do not to interfere with the JTE functionality. When the first conductivity type corresponds to p-type and the second conductivity type to n-type, the depth of the implants may for instance be N+ depth=10-20% of the JTE depth, P+ depth=20-30% of the JTE depth. For example: JTE depth 1 µm, N+=0.15 µm, P+=0.25 µm.

### DESCRIPTION OF THE DRAWINGS

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
Figure 1 illustrates a general top view of a semiconductor device.
Figure 2 illustrates a cross section of a first aspect of a semiconductor device according to the present disclosure.
Figures 2 A-F illustrate close-up views of a cross section of different examples of a semiconductor device according to the first aspect of the present disclosure.
Figure 3 illustrates a cross section of a second aspect of a semiconductor device according to the present disclosure.
Figures 3 A-E illustrate close-up views of a cross section of different examples of a semiconductor device according to the second aspect of the present disclosure.

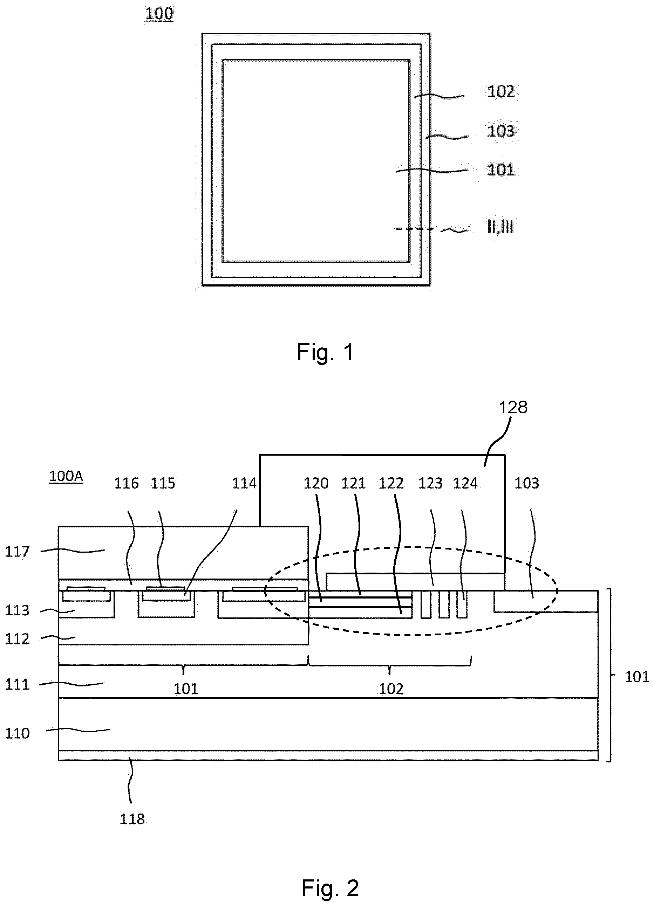

In figure 1, a general top view of a semiconductor device 100 is shown that comprises an active area 101 in which a semiconductor device is realized, a termination area 102 adjacent to active area 101, and a channel stopper 103. Typically, semiconductor device 100 is made from a semiconductor wafer on which a plurality of devices 100 are simultaneously formed. Channel stopper 103 may, prior to separating the devices, comprise structures, such as a saw lane, that allow the devices to be separated. Another structure that is or could be present in channel stopper 103 is a part of the passivation layer.

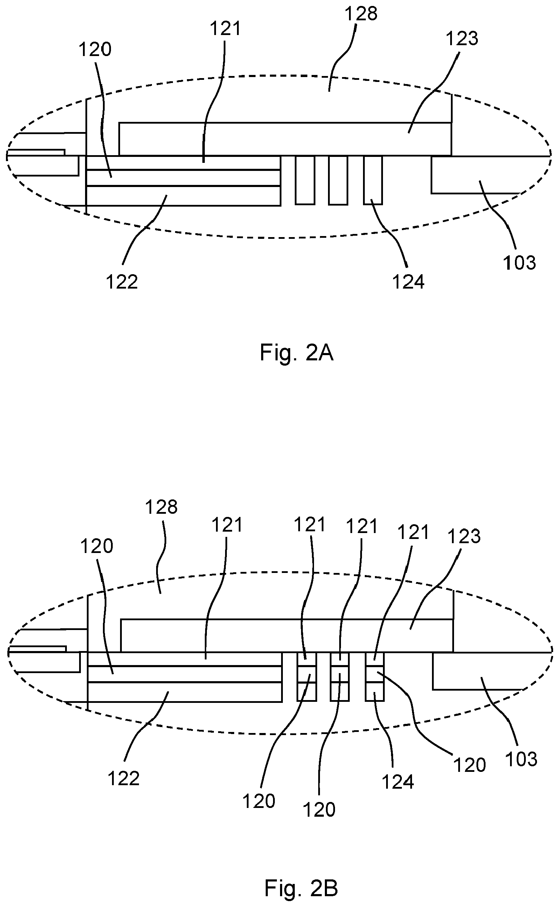

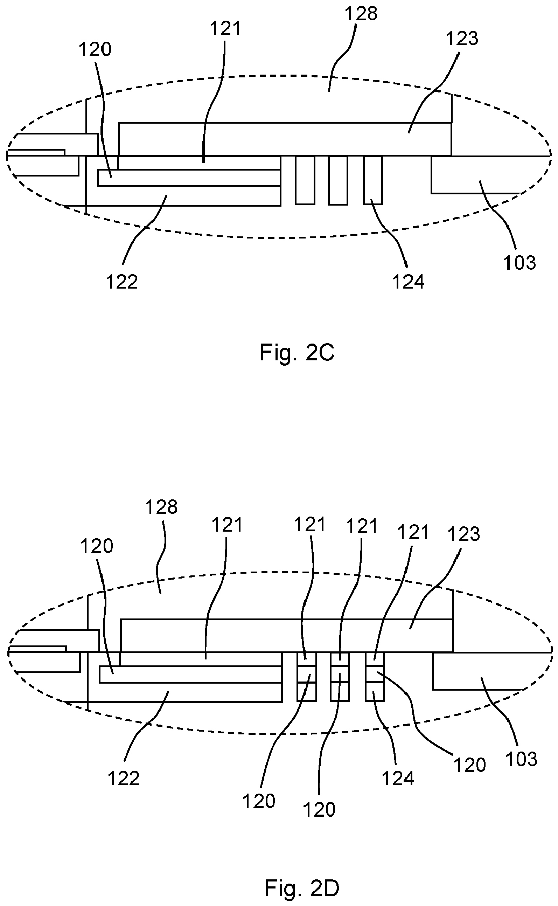

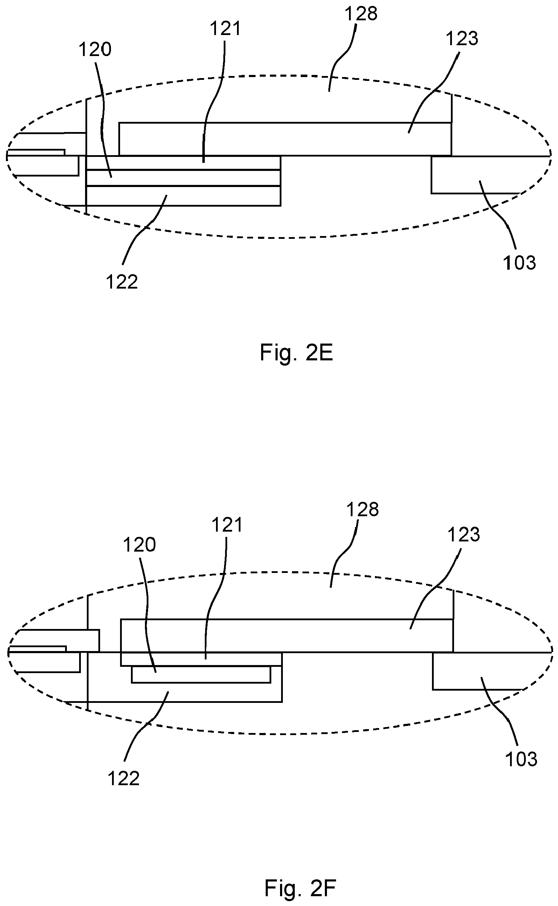

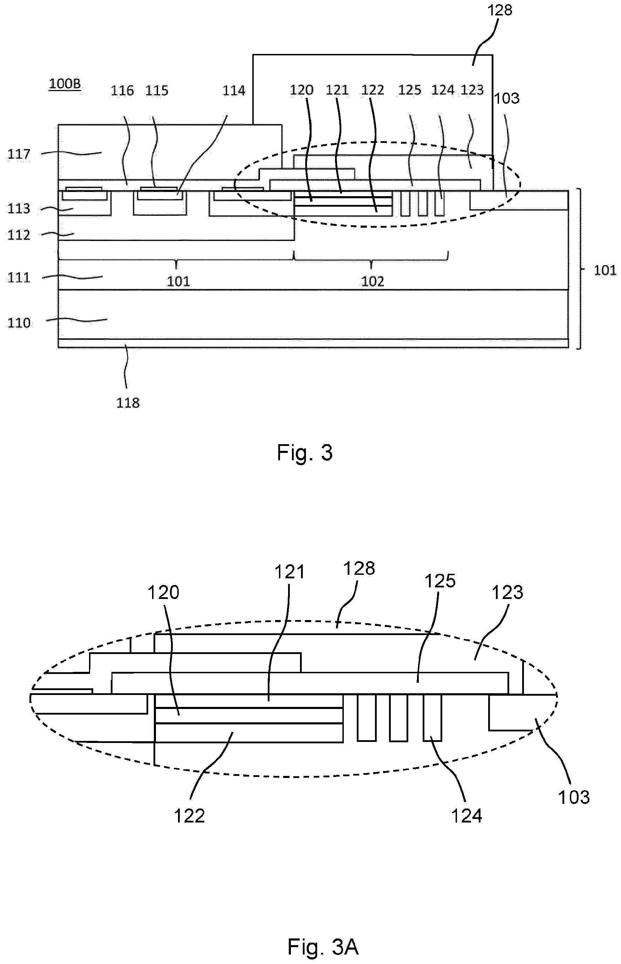

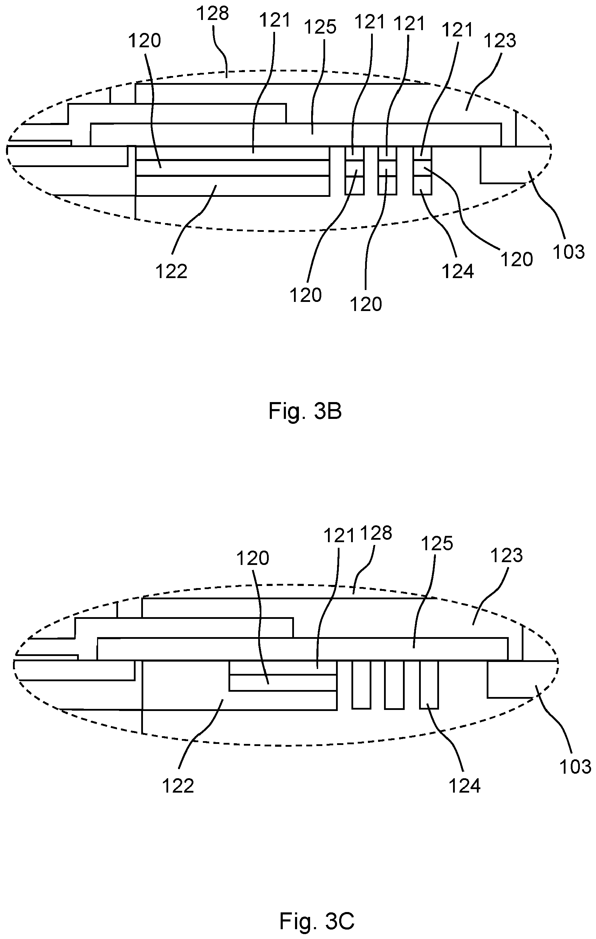

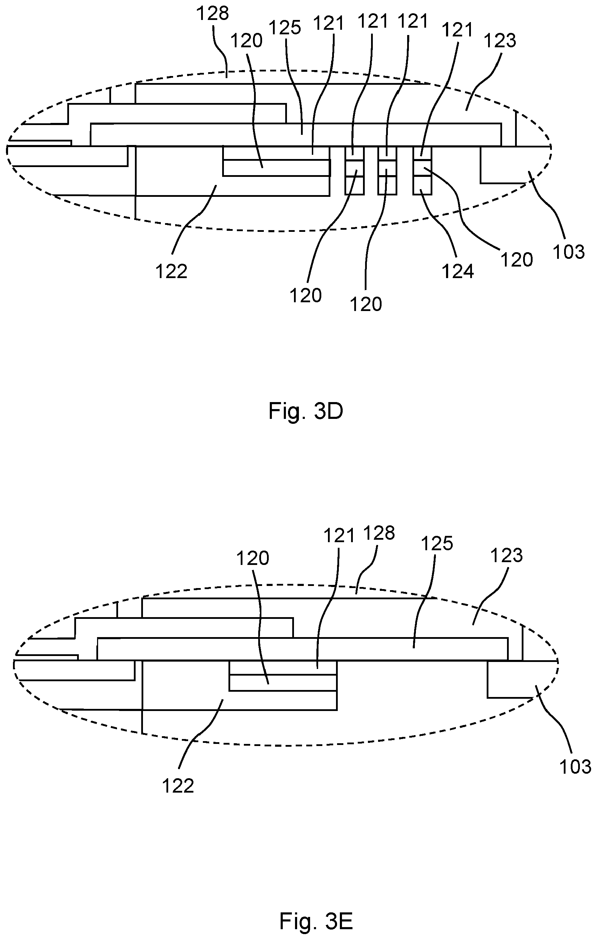

Figures 2 and 3 present cross sections that correspond to the dashed line in figure 1. Here, it is noted that those figures present an exemplary example of a semiconductor device in the form of a SiC MPS diode. However, the present disclosure is not limited thereto and aspects of the present disclosure could equally be applied to other semiconductor devices such as MOSFETs, JFETs, Schottky barriers, or PN diodes, realized on different semiconductor material technologies such as Si, GaN, AlGaN and other II-VI or III-V semiconductor materials.

Now referring to figure 2, MPS diode 100A comprises a semiconductor body 101 comprising an n-type SiC substrate 110 on which an n-type SiC epitaxial layer 111 has been grown. Typical dopant concentrations in these layers are 1E19 #/cm3 and 1E16 #/cm3, respectively. Inside epitaxial layer 111, a n-type current spreader 112 with a typical dopant concentration of 5E16 #cm3 has been formed using ion implantation. In turn, inside current spreader 112, a plurality of p-type wells 113 have been formed using ion implantation. Inside wells 113, highly doped p-type contact regions 114 have been formed using ion implantation to allow low Ohmic contact resistance with an NiSi conductive layer 115. Typical dopant concentrations for wells 113 and contact region 114 are 1E18 #/cm3 and 1E20 #cm3, respectively.

MPS diode 100A further comprises a Ti/TiN layer 116 covering the top surface of current spreader 112 and NiSi layer 115. At the regions where layer 116 contacts current spreader 112, i.e. in between wells 113, a Schottky contact is formed, whereas the NiSi layer 115 forms an Ohmic contact with contact region 114. Ti/TiN layer 116 is covered by a relatively thick AlCu layer 117 that forms a first contact terminal of MPS diode 100A. NiSi layer 115, Ti/TIN layer 116, and AICu layer 117 may jointly be referred to as conductive layer assembly. MPS diode 100A further comprises a polyimide layer 128. Furthermore, a second contact terminal of MPS diode 100A is formed at a backside of SiC substrate 110.

Termination area 102 comprises a p-type layer 120 having a typical dopant concentration of 1E20 #/cm3. On top of p-type layer 120, an n-type second layer 121 is arranged that has a typical dopant concentration of 5E19 #/cm3. Both first and second layers 120,121 are provided inside a p-type JTE border 122 having a typical dopant concentration of 5E17 #/cm3. Adjacent to JTE border 122, a plurality of p-type JTE rings 124 are arranged that have a typical dopant concentration of 5E17 #/cm3. In between channel stopper 103 and active area 101, a passivation layer 123 is provided that is made of Silicon Nitride, Silicon Oxynitride, Silicon Oxide, Metallic Oxide or a suitable combination thereof. As shown, passivation layer 123 does not extend over the entire surface between channel stopper 103 and active area 101. Layer 121 and rings 124 are generally electrically floating during operation.

As an alternative, the passivation layer 123 may extend and also cover the AICu layer 117, such that the polymide layer 128 is isolated from the AICu layer 117.

Figure 2 presents several structures inside termination area 102. More in particular, MPS diode 100A comprises first layer 120, second layer 121, JTE border 122, and JTE rings 124. Among these structures, JTE rings 124 are optional. Several different examples are therefore possible according to aspects of the present disclosure as outlined in the list below:
Fig. 2A: Example 1: layer 120, layer 121, JTE border 122, JTE rings 124 (as shown in figure 2)
Fig. 2B: Example 2: layer 120, layer 121, JTE border 122, JTE rings 124 with the rings having a first p-type layer and a second n-type layer.
Fig. 2C: Example 3: layer 120, layer 121, JTE border 122, JTE rings 124
Fig. 2D: Example 4: layer 120, layer 121, JTE border 122, JTE rings 124 with the rings having a first p-type layer and a second n-type layer.
Fig. 2E: Example 5: layer 120, layer 121, JTE border 122
Fig. 2F: Example 5: layer 120, layer 121, JTE border 122

The list above indicates which structures are possible in the various different examples.

Figure 3 illustrates a further MPS diode 100B that differs from MPS diode 100A in that a field oxide 125 made of Silicon Oxide is used as passivation layer instead of passivation layer 123 for directly contacting the top surface of semiconductor body 101. Contrary to passivation layer 123, field oxide 125 spans the entire surface between channel stopper 103 and active area 101. In addition, Ti/TiN layer 116 partially covers field oxide 125. In addition, a passivation layer 123 is arranged above part of Ti/TiN layer 116 and field oxide 125. In the examples of figures 2 and 3, a separate conductive layer, i.e. NiSi layer 115, was used for realizing an Ohmic contact. In other examples, a same conductive layer, for example comprising one or more metal layers, may be used for simultaneously forming the Ohmic contact to p-type wells 113 and the Schottky contacts to current spreader 112.

Several different examples are therefore possible according to aspects of the present disclosure as outlined in the list below:
Fig. 3A: Example 1: layer 120, layer 121, JTE border 122, JTE rings 124 (as shown in figure 2)
Fig. 3B: Example 2: layer 120, layer 121, JTE border 122, JTE rings 124 with the rings having a first p-type layer and a second n-type layer.
Fig. 3C: Example 3: layer 120, layer 121, JTE border 122, JTE rings 124
Fig. 3D: Example 4: layer 120, layer 121, JTE border 122, JTE rings 124 with the rings having a first p-type layer and a second n-type layer.
Fig. 3E: Example 5: layer 120, layer 121, JTE border 122

The list above indicates which structures are possible in the various different examples.

The ensuing description above provides preferred exemplary example(s) only, and is not intended to limit the scope, applicability or configuration of the disclosure. Rather, the ensuing description of the preferred exemplary example(s) will provide those skilled in the art with an enabling description for implementing a preferred exemplary example of the disclosure, it being understood that various changes may be made in the function and arrangement of elements, including combinations of features from different examples, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology.

While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the description explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

In the description above, for the purposes of explanation, numerous specific details are set forth in order to provide a thorough understanding of implementations of the disclosed technology. It will be apparent, however, to one skilled in the art that examples of the disclosed technology may be practiced without some of these specific details.

### LIST OF ELEMENTS IN THE DRAWINGS

- 100: semiconductor device
- 101: active area
- 102: termination area
- 103: channel stopper
- 110: substrate
- 111: epitaxial layer
- 112: current spreader
- 113: wells
- 114: contact regions
- 115: conductive layer
- 116: Ti/TiN layer
- 117: AlCu layer
- 120: first layer of a first conductivity type
- 121: second layer of a second conductivity type
- 122: JTE border
- 123: passivation layer
- 124: JTE rings
- 125: field oxide
- 128: polyimide layer

## Claims

1. A semiconductor device, comprising:
a semiconductor body including a semiconductor substrate and an epitaxial layer formed on the semiconductor substrate, wherein an active area and a termination area adjacent the active area are arranged in the epitaxial layer;
wherein the termination area comprises a junction termination extension, JTE, border of a first conductivity type;
wherein the JTE border comprises a first layer of the first conductivity type, and a second layer of a second conductivity type different from the first conductivity type;
wherein the second layer is located on top of the first layer;
wherein the semiconductor substrate and the epitaxial layer have the second conductivity type.

2. The semiconductor device according to claim 1, wherein a dopant concentration in the epitaxial layer associated with the second conductivity type is smaller than a dopant concentration in the second layer associated with the second conductivity type.

3. The semiconductor device according to claim 2, wherein the dopant concentration of the JTE border associated with the first conductivity type is at least 20 times smaller than the dopant concentration of the first layer associated with the first conductivity type, preferably at least 50 times smaller, more preferably at least 100 times smaller.

4. The semiconductor device according to any of the previous claims, wherein a dopant concentration in the second layer associated with the second conductivity type is at least 100 times larger than a dopant concentration in the epitaxial layer associated with the second conductivity type, preferably at least 1000 times larger, and more preferably at least 10000 times larger.

5. The semiconductor device according to any of the previous claims, wherein the first and second layers are configured to be electrically floating during operation.

6. The semiconductor device according to any of the previous claims, further comprising a floating bias metal contact connected to the second layer for providing a bias voltage to said second layer.

7. The semiconductor device according to any of the previous claims, wherein the termination area further comprises a plurality of floating JTE rings of the first conductivity type arranged spaced apart from the JTE border; preferably wherein each of the plurality of floating JTE rings comprises a first layer of the first conductivity type, and a second layer of a second conductivity type different from the first conductivity type; wherein the second layer is located on top of the first layer.

8. The semiconductor device according to any of the previous claims, wherein the device further comprises a passivation layer;
wherein the termination area is at least partially covered by the passivation layer;
preferably wherein the passivation layer comprises Silicon Nitride, Silicon Oxynitride, Silicon Oxide or a Metallic Oxide; and/or wherein the passivation layer comprises a field oxide, preferably comprising Silicon Oxide.

9. The semiconductor device according to any of the previous claims, wherein the device further comprises a channel stopper arranged at or near an edge of the semiconductor device, wherein the termination area is arranged in between the channel stopper and the active area, and wherein the channel stopper is of the second conductivity type.

10. The semiconductor device according to any of the previous claims, wherein the passivation layer is covered by the second layer at least on the side of the active area.

11. The semiconductor device according to any of the previous claims, wherein thee layers of the first and second conductivity type are implants located below the passivation, preferably wherein the depth of the implants of the second conductivity type is between 10-20% of the JTE depth, and/or wherein the depth of the implants of the first conductivity type is between 20-30% of the JTE depth.

12. The semiconductor device according to any of the previous claims, wherein the semiconductor device comprises a Merged P-I-N Schottky, MPS, diode, a MOSFET, a JFET, a Schottky barrier, or a PN diode.

13. The semiconductor device according to claim 12, wherein the semiconductor device comprises a MPS diode, and wherein the active area comprises:
a conductive layer assembly comprising one or more conductive layers, such as a metal layers;
a plurality of mutually separated islands of the first conductivity type arranged in a current distribution layer of the second conductivity type;
wherein the conductive layer assembly forms Schottky contacts with the current distribution layer; and
wherein the conductive layer assembly forms Ohmic contacts with the plurality of islands of the first conductivity type;
wherein the conductive layer assembly forms a first contact of the MPS diode; and
wherein the MPS diode comprises a second contact arranged on the semiconductor substrate.

14. The semiconductor device according to any of the previous claims, wherein the semiconductor substrate comprises a Group II, III, IV, V or VI element, preferably wherein the substrate is selected from Silicon Carbide, Silicon, Gallium Nitride, and Aluminum Gallium Nitride, more preferably wherein the substrate is Silicon Carbide.

15. The semiconductor device according to any of the previous claims, wherein the first conductivity type corresponds to p-type and the second conductivity type to n-type.
